# EUROPÄISCHE PATENTANMELDUNG

(11) **EP 1 075 085 A1**
(43) Veröffentlichungstag der Anmeldung: **07.02.2001**
(21) Anmeldenummer: 99250261.7
(22) Anmeldetag: 03.08.1999
(51) Int. Cl.: H03K 17/94

(54) **Drahtlos helligkeitsgesteuerter elektrischer kombinationsfähiger Schalter**

(71) Anmelder: Slamecka, Ernst, 13595 Berlin (DE)
(72) Erfinder: Slamecka, Ernst, 13595 Berlin (DE)

(57) **Zusammenfassung**

Die Erfindung betrifft einen Schalter mit Helligkeitssteuerung durch einen räumlich entfernt angeordneten Photosensor. Installationsprobleme, die sich beim Stand der Technik durch galvanische Verbindungsleitungen ergeben können, eliminiert eine Funkverbindung

Durch Reihenschaltung des über Funk helligkeitsgesteuerten Schalters (11) und eines über eine Schaltuhr zeitgesteuerten Schalters (9) insbesondere im Steuerkreis eines Geräte- oder Leuchtenschalters (10) entsteht ein solcher Schalter mit Funk-Helligkeitssteuerung sowie mit Schaltuhr-Zeitsteuerung.

Bei Energieversorgung des Funksenders (6) durch einen Photovoltaik-Generator (8) können dessen Solarzellen (8a) auch die Funktion des Photosensors übernehmen und diesen als zusätzliches Bauteil einsparen.

Verwendungsmöglichkeiten eines Schalters mit Solarfunk-Helligkeitssteuerung: automatisches helligkeitsabhängiges Schalten von Hausnummernschild-, Straßen-, Garagen- Verkehrsstationen- etc. Beleuchtungen.

Verwendungsmöglichkeiten eines Schalters mit Solarfunk-Helligkeitssteuerung sowie Schaltuhr-Zeitsteuerung: automatisches helligkeits- und zeitabhängiges Schalten von Wohn-, Büro-, Schulraum-, Schaufenster-, Werkstatt-, Krankenhauszimmer-, Hotelzimmer-, Baudenkmal-, etc. Beleuchtungen bzw. Anstrahlungen.

## Beschreibung

Die Erfindung betrifft einen elektrischen Schalter, dessen elektromechanische oder elektronische Schaltfunktion ein Photosensor in Abhängigkeit von der Helligkeit bewirkt. Derartige Schalter sind u.a. bekannt als sogenannte Dämmerungsschalter. Damit wird z.B. die Außenbeleuchtung eines Wohnhauses in der Abenddämmerung ein- und in der Morgendämmerung wieder ausgeschaltet.

Herkömmlich bilden Schalter und Photosensor eine Baueinheit. In diesem Fall müssen Spannung führende, z.B. 220 V, der Witterung ausgesetzte Außenleiter erheblicher Länge zum Montageort des Photosensor-Schalters an einer Außenwand des Hauses und von dort wieder zurück in einen Innenraum geführt werden, wo sich die Anschlußstelle an die Zuleitung zu einer Außenleuchte befindet - alles in allem ein umständlicher, auch kostenaufwendiger Montagevorgang.

Es ist zwar bekannt, den Photosensor als vom Schalter getrentes und mit diesem durch ein Kabel verbundenes Bauteil auszuführen, US-Patent 3,673,913; doch auch hierbei sind im Fall der Außeninstallation lange Anschlußleitungen in Freiluftausführung notwendig. Und nach wie vor wird für ein jedes Haus mit zu beleuchtendem Außenobjekt ein kompletter Photosensorschalter gebraucht. Denn eine Photosteuerung mehrerer Schalter z.B. für die Hausnummernbeleuchtung an den Häusern einer Wohnsiedlung oder Fabrikenanlage durch einen gemeinsamen Photosensor ist wegen der langen Steuerleitungen praktisch kaum ausführbar.

Gemäß dem vorstehend beschriebenen Stand der Technik ergeben sich erfinderische Aufgaben wie folgt:
- bei getrennter Anordnung von Schalter und Photosensor soll die Installation der beiden Komponenten in einfacher Weise und funktionsoptimal erfolgen;
- der Photosensorschalter soll einfach mit einem anderen gesteuerten Schalter, z.B. mit einer Schaltuhr, kombinierbar sein;
- die Photosteuerung mehrerer Schalter durch nur einen Photosensor soll keinen Mehraufwand verursachen.

Die erfinderischen Aufgaben werden durch die Merkmale des Patentanspruchs 1 sowie der Nebenansprüche 4 und 6 gelöst. Vorteilhafte Weiterbildungen sind in den Unteransprüchen beschrieben.

Das Wesentliche der Erfindung besteht in folgendem:
- die galvanische Verbindungsleitung zwischen einem über die Helligkeit gesteuerten Schalter und dem steuernden Photosensor ersetzt eine Funkverbindung;
- die Helligkeitssteuerung eines einzelnen Schalters ebenso wie mehrerer Schalter bewerkstelligt stets ein Photo-Steuersignalsender.
- die Kombination des drahtlos helligkeitsgesteuerten Schalters mit einer programierbaren Schaltuhr ergibt einen Licht-Zeit-Schaltautomaten mit Licht-Funksteuerung; auch mehrere Licht-Zeit-Schaltautomaten steuert ohne Mehraufwand stets nur ein Photo-Steuersignalsender;
- der Photo-Steuersignalsender erhält die Eigenbedarfsenergie von einem Photovoltaik-Generator mit gleichzeitiger Funktion als Photosensor.

Drei Ausführungsbeispiele erläutern die Erfindung; es zeigen:
- Fig. 1:: Schalter 4 mit drahtloser Helligkeitssteuerung in Verbraucher-Stromkreis 3; Energiebezug des Photo-Steuersignalsenders 6 fakultativ aus Stromnetz, Batterie/Akku oder Photovoltaik-Generator.
- Fig. 2:: Schalter 4 mit drahtloser Helligkeitssteuerung und eine Schaltuhr mit programmierbarer Zeitsteuerung 9 in Verbraucherstromkreis 3; Energiebezug des Photo-Steuersignalsenders 6 aus Photovoltaik-Generator 8 mit gleichzeitiger Funktion als Photosensor.
- Fig. 3:: In Verbraucherstromkreis 3 ein Schalter 10; sein Auslösestromkreis 10a versehen mit drahtloser Helligkeitssteuerung 11 und 9 programmierbarer Zeitsteuerung; Energiebezug aus Photovoltaik-Generator 8 mit gleichzeitiger Funktion als Photosensor.

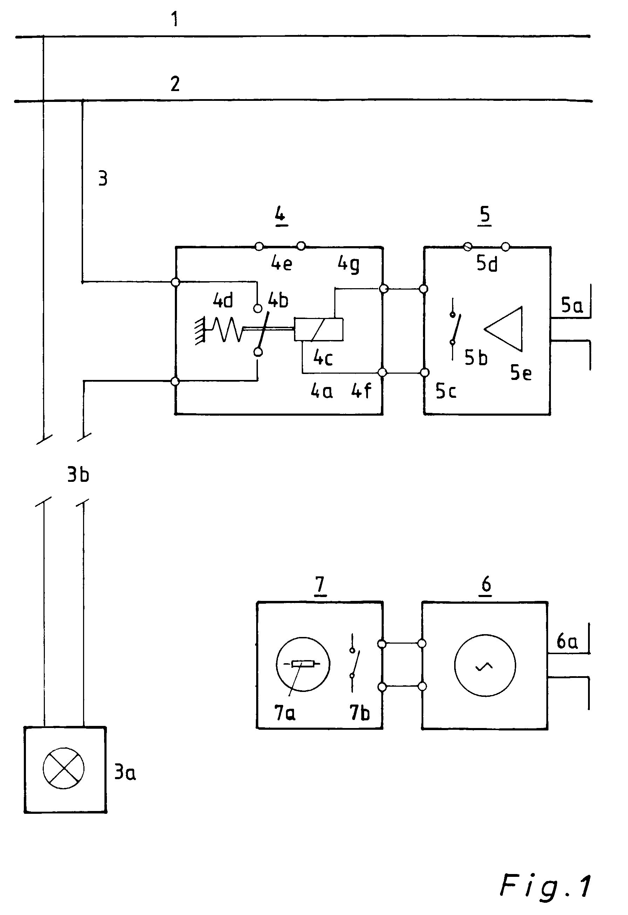

Fig. 1, erstes Ausführungsbeispiel, zeigt einen Schalter 4 mit drahtloser Helligkeitssteuerung 5 , 6 , 7 in einem Verbraucherstromkreis 3 mit darin befindlichem Energieverbraucher 3a, z.B. eine Beleuchtungslampe für ein Hausnummernschild. Die Schnittstelle 3b im Verbraucherstromkreis 3 soll den Innen- und Außenbereich dieses Kreises andeuten. Der Verbraucher-stromkreis ist an Phasen- und Nulleiter 1 bzw. 2 eines weiter nicht dargestellten Stromnetzes angeschlossen.

Bei Unterschreiten eines Helligkeitswertes wird ein Sender 6 durch einen Photosensor 7 mit einem Photowiderstand 7a oder einem nicht dargestelltem Photohalbleiter als dem Reakionselement auf Helligkeitsänderungen in Betrieb gesetzt, was elektromechanisch mit einem Schalter 7b oder, nicht dargestellt, elektronisch erfolgt. Das über eine Dipolantenne 6a ausgestrahlte Funksignal veranlasst in einer mit Dipolantenne 5a, Empfänger/Verstärker 5e und Schalter 5b ausgestatteten Funkempfänger-Schalteinheit 5, den Auslösestromkreis 4a und so den Schaltkontakt 4b durch die Antriebsmagnetspule 4c gegen die Kraft der Kontaktantriebsfeder 4d zu schließen. Damit wurde die Beleuchtung eingeschaltet.

Der Auslösestromkreis 4a im Schaltergehäuse 4g und die hier getrennt davon angeordnete Funkempfänger-Schalteinheit 5 sind über die Anschlußklemmen 4f bzw. 5c elektrisch verbunden. Diese Einheit 5 kann auch in nicht dargestellter Weise in das Schaltergehäuse 4g integriert sein.

Bei Überschreiten eines Helligkeitswertes unterbricht der Photosensor 7 den Betrieb des Senders 6 und damit dessen Funksignale. Die Antriebsmagnetspule 4c im Auslösestromkreis 4a wird stromlos. Die Antriebsfeder 4d öffnet den Kontakt 4b. Die Beleuchtung des Hausnummernschilds ist damit ausgeschaltet.

Bildlich nicht dargestellt können weitere Photosensorschalter 4 in anderen Verbraucherstromkreisen im selben Raum oder in davon getrennten Räumen durch einen zentralen Photosensor 7 mit Steuersignalsender 6 helligkeitsabhängig gesteuert werden.

Photosensor und Sender 6 sind zur Eigenbedarfsenergieversorgung über nicht dargestellte Anschlußklemmen an das allgemeine Stromnetz anges-chlossen. Statt räumlich getrennt können Sender und Photosensor auch zu einer nicht dargestellten Baugruppe vereinigt sein, etwa in Gießharz eingebettet. Die Energie für den Eigenbedarf können auch Batterie oder Akku liefern.

In einer fortschrittlichen Weiterbildung der Erfindung bezieht der Sender 6 seine Eigenbedärfsenergie von einem autarken Photovoltaik-Generator. Dieses Verfahren erspart neben umständlich zu verlegenden Anschlußleitungen auch noch den Photosensor, was alles im zweiten Ausführungsbeispiel beschrieben werden wird.

Hin- und Rückleitung des Verbraucherstromkreises 3 können auch durch das Gehäuse 4g des Schalter 4 hindurchgeführt sein. Bei dieser nicht dargestellten Ausführungsart befindet sich auch der Parallelanschluß für den Eigenbedarf innerhalb des Schaltergehäuses mit nun zwei Eingangs- und zwei Ausgangs-Klemmen oder Buchsen. Analoges gilt für den Empfänger/Verstärker 5 in der dargestellten nicht integrierten Ausführung.

Definition der Helligkeit: in Verbindung mit der Lichtstärke (Candela) ist sie die Helligkeit der Lichtquelle; in Verbindung mit der Beleuchtungsstärke (Lux) ist sie die Helligkeit einer beleuchteten Fläche.

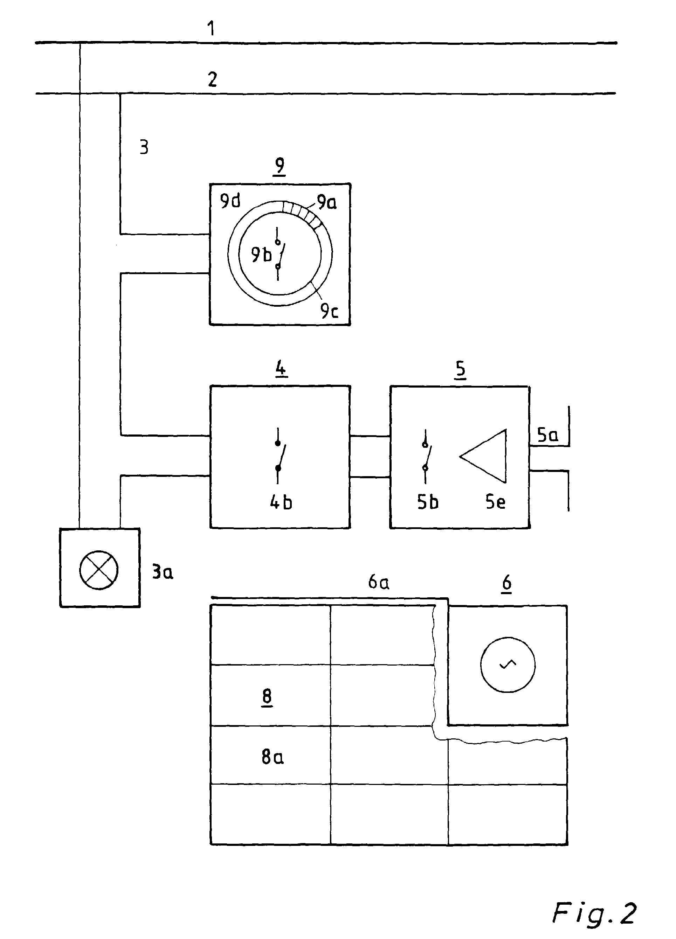

Fig. 2, zweites Ausführungsbeispiel, zeigt den Schalter 4 mit drahtloser Helligkeitssteuerung 5, 6, 8a im Verbraucherstromkreis 3 - Energieverbraucher 3a etwa eine Zimmerstehlampe - und desweiteren darin ein Betriebszeitschalter 9. Wie vorstehend schon durch die Bezugszeichenfolge 5, 6, 8a angedeutet, werden unter Einsparung des eigenständigen Photosensors 7 die Solarzellen 8a des Photovoltaik-Generators 8 auch noch als Photosensor verwendet; das folgt: in der Abenddämmerung stellt der Steuersignalsender 6 wegen schwindender Energieerzeugung der Solarzellen den Betrieb ein. Wegen des dann fehlenden Funksignals läßt der Empfänger/Verstärker 5 den Schalter 4 einschalten. Bei elektromagnetischer Bauart erfolgt dies durch Unterbrechen eines Relaisstromkreises 4a mit der Antriebsmagnetspule 4c und anschließendem Einschalten des Schaltkontakts 4b durch eine Antriebsfeder 4d; bezüglich der Bauteile des Auslösestromkreises 4a siehe Fig. 1. Somit ist die Zimmerstehlampe eingeschaltet.

In der Morgendämmerung läuft der Steuerungsvorgang umgekehrt ab: die Solarzellen 8a beginnen mit der Energieerzeugung; der Sender 6 strahlt ein Funksignal aus; der Empfänger/Verstärker empfängt und verstärkt es und läßt damit den Schalter 4 ausschalten, indem der Relaisstromkreis 4a geschlossen wird und eine Antriebsmagnetspule 4c den Schaltkontakt 4b gegen die Kraft der Antriebsfeder 4d öffnet; die Zimmerstehlampe ist ausgeschaltet.

Bei elektronischer Bauart des Schalters 4 übernimmt die Rolle des gesteuerten Schaltkontakts 4b ein nicht dargestellter Schalttransistor, dessen Basiskreis entsprechend dem von der Funk-Steuerungseinheit 5 empfangenen und verstärkten Funksignal den Kollektorkreis des Schalttransistors schließen bzw. öffnen.

Der Sender 6 ist auf der Rückseite eines von den Solarzellen 8a des Photovoltaik-Generators 8 gebilden Paneels angeordnet. Es wird eine Stabantenne 6a verwendet, die an der Schmalseite des Paneels geführt ist, aber auch senkrecht dazu in den freien Raum hineinstehen kann.

Auch eine nicht dargestellte Rahmenantenne kann verwendet werden. Die elektrischen Verbindungen zwischen Photovoltaik-Generator und Sender sind in der Zeichnung nicht sichtbar.

Sender 6 und Photovoltaik-Generator 8 können in eine Isoliermasse, z.B. Gießharz, eingebettet sein und als autarke wetterfeste Einheit lichttechnisch optimal positioniert werden, was nicht dargestellt ist.

Die Betriebszeit-Schaltuhr 9, hier in elektromechanischer Bauart, weist außen eine synchron rotierende Ziffernscheibe 9c mit den Stundenziffern 1 bis 24 am Außenrand auf. Mit den radial verschiebbaren, die Ziffernscheibe wie ein Kranz umgebenden Sektoren 9a läßt sich ein Zeitprogramm für die Betätigung eines im Schaltuhrengehäuse 9d angeordneten Schalters 9b des Verbraucherstromkreises 3 einstellen; äuch ein durchaus elektronischer Zeitschalter (9) ist ausführbar. In Kombination mit dem durch die Helligkeit per Funk gesteuerten Schalter 4 kann ein Licht-Zeit-Schaltprogramm für die Stehlampe wie folgt ablaufen:
- bei geschlossenem Zeitschalter 9 schließt der Photoschalter 4 bei Unterschreiten eines Wertes der Helligkeit während der Abenddämmerung; damit beginnt das erste Betriebsintervall der Zimmerstehlampe;
- nachfolgend öffnet bei geschlossenem Photoschalter 4 der Zeitschalter 9, wenn es Zeit ist für die Nachtruhe, z.B. um 23^{h}; damit endet das erste Betriebsintervall der Zimmerstehlampe;
- nachfolgend schließt bei geschlossenem Photoschalter 4 der Zeitschalter 9, wenn es noch dunkel aber Zeit ist zum Aufstehen, z.B. um 6^{h}; damit ist die Zimmerstehlampe wieder eingeschaltet; das zweite Betriebsintervall beginnt; allerdings nur dann, wenn es um diese Zeit, im Winter, noch dunkel ist; im Sommer ist es um 6^{h} schon hell; der Photoschalter 4 hat um diese Zeit bereits geöffnet; der "mitdenkende" Funk-Licht-Zeit-Schaltautomat setzt also während des Sommers die Zimmerstehlampe nur allabendlich in Betrieb;
- nachfolgend öffnet bei geschlossenem Zeitschalter 9 der Photoschalter 4 bei Überschreiten eines Wertes der Helligkeit während der Morgendämmerung - evtl. mit zeitlicher Verzögerung; damit endet das zweite Betriebsintervall der Zimmerstehlampe - falls es Winter, Vorfrühling oder Spätherbst ist;
- nachfolgend öffnet bei geöffnetem Photoschalter 4 der Zeitschalter 9;
- nachfolgend schließt bei geöffnetem Photoschalter 4 der Zeitschalter 9 und bereitet damit ein Wiederholen der allabendlichen und gegebenenfalls auch allmorgentlichen Betriebsintervalle der Zimmerstehlampe oder auch eines anderen durch die Funk-Licht-Zeit-Schaltautomatik zu schaltenden Verbrauchers elektrischer Energie vor.

Zeitschalter 9 und zumindest Funk-Photoschalter 4 mit Empfänger/Verstärker 5 zu einer beispielsweise vollelektronischen Baueinheit vereinigt können als Einzelgeräte auch noch in weiteren Verbraucherstromkreisen in demselben Raum oder gegebenenfalls in anderen Räumen zur Funk-Licht-Zeit-Steuerung darin angeordneter Leuchten und/oder anderer Verbraucher elektrischer Energie eingesetzt sein; dabei erfolgt die Photosteuerung über Funk stets durch einen gemeinsamen Sender 6, was nicht dargestellt ist. Unter "Raum" und "Räume" werden verstanden: Zimmer in einer Wohnung, Hotelzimmer, Schaufenster, Büroräume, Fabrikationsräume, Schaufenster etc. Bei den ausgedehnteren Objekten für eine Funk-Licht-Zeitsteuerung muß nur ein Sender 6 mit größerer Reichweite und einem Photovoltaik-Generator 8 entsprechend größerer Leistung verwendet werden.

Die Betriebszeiten z.B. der Beleuchtung verschiedener Räume können unterschiedlich programmiert sein: a) durch unterschiedliche Schaltzeitprogramme der Betriebszeitschaltuhren 9 und b) bei den Funk-Photoschaltern 4 durch unterschiedlich zeitlich verzögertes Schalten. So läßt sich, praktisch perfekt, Anwesenheit simulieren in einer vorübergehend nicht benutzten Wohnung oder Belegung von Hotelzimmern; letzteres ist auch werbewirksam und kann eine teuere Neonreklame ersetzten.

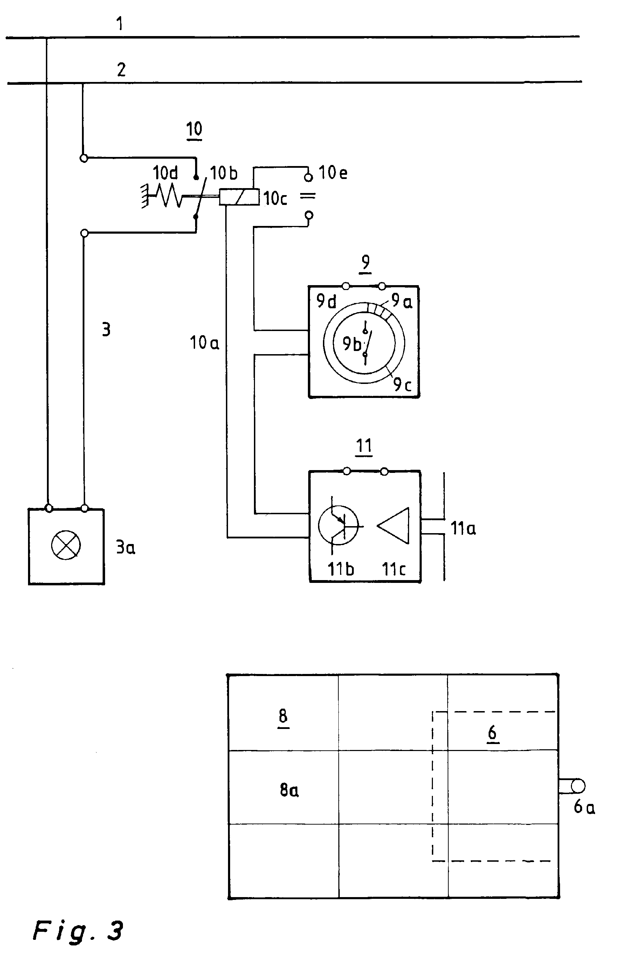

Im Verbraucherstromkreis 3 der Fig. 3, drittes Ausführungsbeispiel, befindet sich gemäß Weiterbildung einer Ausführung der Erfindung wie durch das zweite Ausführungsbeispiel näher erläutert, Fig. 2, nur noch ein Schalter 10 für ein gesteuertes Schalten eines oder mehrerer Betriebsintervalle eines Verbrauchers elektrischer Energie 3a, z.B. einer Raumbeleuchtung, in Abhängigkeit von Helligkeit und Zeit. Die Steuerungsmittel sind im Auslöse- oder Steuerkreis 10a des Schalters 10 angeordnet und bestehen aus:
Schaltkontakt 10b des Schalters 10,
Kontaktantriebsmagnetspule 10c,
Kontaktantriebsfeder 10d,
Schaltuhr als Zeit-Steuerschalter 9,
Empfänger/Verstärker 11c mit Schalttransistor 11b des Photo-Steuerschalters 11,
Anschluß 10e zur Energieversorgung des Steuerungskreises.

Die vorstehend angeführten elektromechanischen Schalt- und Steuermittel können durch nicht dargestellte elektronische ersetzt werden.

Die Schaltuhr als Zeitschalter 9 läßt mit dem Schaltkontakt 9b nach bereits anhand der Fig. 2 beschriebener Verfahrensweise ein -------------- zeitprogrammiertes Schließen bzw. Öffnen im Steuerstromkreis 10a des Schalters 10 ausführen. Ein --------------- von der Helligkeit abhängiges Schließen bzw. Öffnen im Steuerkreis 10a des Schalter 10 führt der durch den auch als Photosensor eingeplanten Funksender 6 lichtabhängig gesteuerte Photoschalter 11 aus. Diese Schaltungen des Zeitschalters 9 und des Photoschalters 11 sind untereinander derart abgestimmt, daß sich zumindest ein sowohl von der zeitlich veränderlichen Helligkeit als auch vom Zeitablauf bestimmtes Betriebsintervall der/des Verbraucher/s elektrischer Energie in automatischer Wiederholung ergibt. Eine Folge von Betriebsintervallen ist z.B. nachstehend programmiert.
- bei geschlossenem Zeit-Steuerschalter 9 im Steuerkreis 10a des Schalters 10 im Verbraucherstromkreis 3 schließt der Funk-Photo-Steuerschalter 11 im Steuerstromkreis 10a des Schalters 10 bei Unterschreiten einesnes Wertes der Helligkeit in der Abenddämmerung - gegebenenfalls mit eingestellter Zeitverzögerung - worauf der Schalter 10 im Verbraucherstromkreis 3 schließt - gegebenenfalls mit der eingestellten Zeitverzögerung;
- nachfolgend öffnet bei geschlossenem Funk-Photo-Steuerschalter 11 der Zeit-Steuerschalter 9 im Steuerkreis 10a des Schalters 10 zu einer vorgegebenen Zeit, z.B. um 23^{h}, worauf der Schalter 10 im Verbraucherstromkreis 3 öffnet;
- nachfolgend öffnet bei geöffnetem Zeit-Steuerschalter 9 der Funk-Photo-Steuerschalter 11 im Steuerkreis 10a des Schalters 10 bei Überschreiten eines Ansprechwertes der Helligkeit während der Morgendämmerung;
- nachfolgend schließt bei geöffnetem Funk-Photo-Steuerschalter 11 der Zeit-Steuerschalter 9 im Steuerkreis 10a des Schalters 10 zu einer vorgegebenen Zeit, z.B. um 11^{h}, worauf nachfolgend in der Abenddämmerung das eingestellte Schaltprogramm mit dem Schließen des Funk-Photo-Steuerschalters 11 im Steuerkreis 10a des Schalter 10 im Verbraucherstromkreis 3 von neuem beginnt.

Die Betriebsenergie des Funksenders 6 liefert ein Photovoltaik-Generator 8a; seine Solarzellen 8a sind auch noch in der Funktion eines Photosensors eingesetzt.

Die Anschlüsse der Zeitschaltuhr 9 und des Empfänger/Verstärker/Auslösers 11 sind innerhalb des nicht dargestellten Gehäuses des Schalters 10 angeordnet und darin in nicht dargestellter Weise an die Betriebsspannung angeschlossen; einschlägiges dazu steht in der Beschreibung zu Figur 1.

Funk-Photo-Zeit-Steuerschalter in der Bauart des Schalters 10, wobei man gegenüber der getrennten Bauart --- Steckdose ------ und Stecker einspart, lassen sich ---- sehr einfach in verschiedene, auch in getrennten Räumen befindliche Verbraucherstromkreise installieren und können darin bezüglich ihres von Zeitablauf und zeitlich veränderlicher Helligkeit bestimmten Schaltens auch verschieden programmiert sein. Dabei erfolgt die Helligkeitssteuerung des Photo-Steuerschalters 11 weiterhin nur durch einen gemeinsamen Funksender 6.

## Patentansprüche

1. Helligkeitsgesteuerter elektrischer Schalter mit einem davon räumlich entfernt positionierten, die Funktion dieses in einem Stromkreis (3), (10a) angeordneten Schalters (4), (10) in Abhängigkeit von der Helligkeit steuernden Photosensor (7), (8a), gekennzeichnet durch folgende Merkmale:
der in einem Verbraucherstromkreis (3) angeordnete Schalter (4) ist in seiner sich durch Schließungen und Öffnungen manifestierenden Funktion von einem Photosensor (7), (8a) über eine durch einen Funk-Sender (6) und einen Funk-Empfänger/Verstärker/Schalter (5) gebildete drahtlose Verbindung in Abhängigkeit von der Helligkeit gesteuert.

2. Schalter nach Anspruch 1, gekennzeichnet durch folgendes Merkmal:
zumindest die Versorgung des Funk-Senders (6) mit Betriebsenergie erfolgt durch einen Photovoltaik-Generator (8).

3. Schalter nach Anspruch 1, gekennzeichnet durch folgendes Merkmal:
der Photosensor ist als selbständiger Photosensor (7) ausgeführt oder es werden die Solarzellen (8a) des Photovoltaik-Generators (8) zumindest teilweise auch als Photosensoren verwendet.

4. Helligkeitsgesteuerter elektrischer Schalter mit einem davon räumlich entfernt positionierten, die Funktion dieses in einem Stromkreis (3), (10a) angeordneten Schalters (4), (10) in Abhängigkeit von der Helligkeit steuernden Photosensor (7), (8a), gekennzeichnet durch folgende Merkmale:
der in einem Verbraucherstromkreis (3) angeordnete Schalter (4) ist in seiner Funktion durch einen Photosensor (7), (8a) über eine durch einen Funk-Sender (6) und einen Funk-Empfänger/Verstärker/Schalter (5) gebildete drahtlose Verbindung in Abhängigkeit von der Helligkeit gesteuert, wobei in dem Verbraucherstromkreis (3) ein zweiter in seiner Funktion durch eine Zeitschaltuhr in Abhängigkeit von der Zeit gesteuerter Zeitschalter (9) angeordnet ist und die sich durch Schließungen und Öffnungen im Verbraucherstromkreis (3) manifestierenden Schaltungen des ersten Schalters (4) und des zweiten Schalters (9) derart abgestimmt sind, daß sich dadurch zumindest ein sowohl von der zeitlich veränderlichen Helligkeit als auch vom Zeitablauf bestimmtes Betriebsintervall des Energieverbrauchers (3a) im Verbraucherstromkreis (3) ergibt.

5. Schalter nach Anspruch 4, gekennzeichnet durch folgende Merkmale:
die Versorgung des Funk-Senders (6) mit Betriebsenergie erfolgt durch einen Photovoltaik-Generator (8), wobei dessen Solarzellen (8a) zumindest zum Teil die Funktion eines Photosensors ausüben.

6. Helligkeitsgesteuerter elektrischer Schalter mit einem davon räumlich entfernt positionierten, die Funktion dieses in einem Stromkreis (3), (10a) angeordneten Schalters (4), (10) in Abhängigkeit von der Helligkeit steuernden Photosensor (7), (8a), gekennzeichnet durch folgende Merkmale:
der in einem Steuerstromkreis (10a) eines in einem Verbraucherstromkreis (3) eingesetzten Schalters (10) angeordnete Schalter (11) ist in seiner Funktion durch einen Photosensor (7) (8a) über eine durch einen Funksender (6) und einen Funk-Empfänger/Verstärker/Schalter (5) gebildete drahtlose Verbindung in Abhängigkeit von der Helligkeit gesteuert, wobei in dem Steuerstromkreis (10a) ein zweiter in seiner Funktion durch eine Zeitschaltuhr in Abhängigkeit von der Zeit gesteuerter Zeitschalter (9) angeordnet ist und die sich durch Schließungen und Öffnungen im Steuerstromkreis (10a) des Schalters (10) manifestierenden Schaltungen des ersten Schalters (11) und des zweiten Schalters (9) derart abgestimmt sind, daß die dadurch ausgelösten Schaltungen des Schalters (10) im Verbraucherstromkreis (3) zumindest ein sowohl von der zeitlich veränderlichen Helligkeit als auch vom Zeitablauf bestimmtes Betriebsintervall des Energieverbrauchers (3a) in automatischer Wiederholung ergeben.

7. Schalter nach Anspruch 6, gekennzeichnet durch folgende Merkmale:
die Versorgung des Funk-Senders (6) mit Betriebsenergie erfolgt durch einen Photovoltaik-Generator (8), wobei dessen Solarzellen (8a) zumindest zum Teil die Funktion eines Photosensors ausüben.
